# EUROPEAN PATENT APPLICATION

(11) **EP 2 237 415 A2**
(43) Date of publication of application: **06.10.2010**
(21) Application number: 10151920.5
(22) Date of filing: 28.01.2010
(51) Int. Cl.: H03G 3/30

(54) **Broadcasting signal receiving apparatus and control method thereof**

(30) Priority: 31.03.2009 KR 20090027537
(71) Applicant: SAMSUNG ELECTRONICS CO., LTD., Suwon-si, Gyeonggi-do (KR)
(72) Inventor: Choi, Young-ho, Gyeonggi-do (KR)
(74) Representative: Walaski, Jan Filip

(57) **Abstract**

Disclosed are a broadcasting signal receiving apparatus and a control method thereof. The broadcasting signal receiving apparatus comprises: a signal receiver which receives a broadcasting signal comprising at least one future extension frame; a signal sensor which senses a level of the received broadcasting signal; an automatic gain controller which performs automatic gain control to make the broadcasting signal have a certain level according to the sensed level of the broadcasting signal; and a control signal generator which generates a control signal to apply the automatic gain control to the broadcasting signal according to whether the broadcasting signal is in the future extension frame. With this, the AGC is performed according to whether it is the future extension frame or not, thereby preventing the signal from distortion, real-time controlling the AGC to be performed or frozen, and improving adjacent channel interference rate characteristics.

## Description

Apparatuses and methods consistent with the present invention relate to a broadcasting signal receiving apparatus and a control method thereof, and more particularly, to a broadcasting signal receiving apparatus capable of receiving a broadcasting signal including at least one future extension frame, and a control method thereof.

A broadcasting signal receiving apparatus receives a broadcasting signal from a broadcasting station, and processes it to be displayed as an image.
For the broadcasting signal receiving apparatus, there are digital television (DTV) standards such as advanced television systems committee (ATSC) in U.S.A., digital video broadcast-terrestrial (DVB-T) in Europe, integrated services digital broadcasting-terrestrial (ISDB-T) in Japan, etc. Meanwhile, a DVB-T2 more improved in transmission efficiency by about 30% and over than the DVB-T will be serviced as the next generation European standard.

The strength of the broadcasting signal received in the broadcasting signal receiving apparatus such as a TV may vary depending on external factors such as distance from the broadcasting station. For example, the closer to the broadcasting station, the stronger the broadcasting signal; but the farther the weaker.

Therefore, the DVB-T and DVB-T2 standards perform automatic gain control (AGC) to keep a signal level constant by decreasing the signal level if the broadcasting signal is strong and increasing the signal level if the broadcasting signal is weak.

However, the DVB-T2 standard includes a future extension frame (FEF) prepared as a preliminary part for future standards of a broadcasting system succeeding the DVB-T2 standard.

The DVB-T2 standard embeds the future extension frame in a DVB-T2 stream in which broadcasting information is contained.

In the case of the DVB-T2 standard, the future extension frame is a section where there is no broadcasting information, but has a predetermined signal level, so that it can undergo the AGC according to the signal level.

As the AGC is applied to even the section of the future extension frame, the broadcasting signal receiving apparatus takes a time in stabilizing the AGC for decoding DVB-T2 frames consecutive to the future extension frame and may thus abnormally receive the broadcasting signal.

Accordingly, in the case of using the DVB-T2 standard, there is a need for controlling the AGC not to be performed in the section of the future extension frame.

The foregoing and/or other aspects of the present invention can be achieved by providing a broadcasting signal receiving apparatus including: a signal receiver which receives a broadcasting signal including at least one future extension frame; a signal sensor which senses a level of the received broadcasting signal; an automatic gain controller which performs automatic gain control to make the broadcasting signal have a certain level according to the sensed level of the broadcasting signal; and a control signal generator which generates a control signal to apply the automatic gain control to the broadcasting signal according to whether the broadcasting signal is in the future extension frame.

The control signal generator may detect the future extension frame of the received broadcasting signal, and generate a control signal not to perform the automatic gain control in the detected future extension frame.

The control signal generator may includes: a reference value generator which generates a predetermined reference value; and a comparator which compares the level of the sensed broadcasting signal with the reference value, and the automatic gain controller performs the automatic gain control according to comparison results of the comparator.

The broadcasting signal receiving apparatus may further include a signal filter which filters off an adjacent channel signal of the received broadcasting signal, wherein the comparator compares a level of a broadcasting signal of before passing through the signal filter with the reference value.

The control signal generator may include an up/down controller which outputs either of an up signal or a down signal according to the comparison results of the comparator; a counter which outputs a predetermined count signal; and a pulse generator which compares an output value of the up/down controller with an output value of the counter, and generates a pulse width modulation (PWM) signal having a predetermined pulse width, and the automatic gain controller performs the automatic gain control according to an output value of the pulse generator.

The reference value generator may change the reference value to make the output value of the comparator become a new reference value and outputs the new reference value.

The pulse generator may generate a pulse width modulation signal changed in the pulse width according to the change of the reference value.

The broadcasting signal receiving apparatus may further include a signal converter which converts the received broadcasting signal into a broadcasting signal having an intermediate frequency band, wherein the automatic gain controller includes a first automatic gain control amplifier which applies the automatic gain control to the broadcasting signal received in the signal receiver, and a second automatic gain control amplifier which applies the automatic gain control to the broadcasting signal having the intermediate frequency band.

Another aspect of the present invention can be achieved by providing a method of controlling a broadcasting signal receiving apparatus, the method including: receiving a broadcasting signal including at least one future extension frame; sensing a level of the received broadcasting signal; and generating a control signal to apply the automatic gain control to the broadcasting signal according to whether the broadcasting signal is in the future extension frame, and performing automatic gain control to make the broadcasting signal have a certain level according to the sensed level of the broadcasting signal.

The performing the automatic gain control may include detecting the future extension frame of the received broadcasting signal, and generating a control signal not to perform the automatic gain control in the detected future extension frame. The performing the automatic gain control may include generating a predetermined reference value; and comparing the level of the sensed broadcasting signal with the reference value, and the automatic gain control may be performed according to comparison results of the comparator.

The method may further include filtering off an adjacent channel signal of the received broadcasting signal, wherein the comparing with the reference value includes comparing a level of a broadcasting signal of before passing through the signal filter with the reference value.

The comparing with the reference value may include outputting either of an up signal or a down signal according to the comparison results of the comparator; outputting a predetermined count signal; and generating a pulse width modulation (PWM) signal having a predetermined pulse width by comparing an output value of the up/down controller with an output value of the counter, and the performing the automatic gain control may include performing the automatic gain control according to a pulse width of the pulse generator.

The method may further include changing the reference value to make the output value of the comparator become a new reference value and outputting the new reference value.

The method may further include converting the received broadcasting signal into a broadcasting signal having an intermediate frequency band, wherein the performing the automatic gain control includes applying the automatic gain control to the broadcasting signal, and applying the automatic gain control to the broadcasting signal having the intermediate frequency band.

The above and/or other aspects of the present invention will become apparent and more readily appreciated from the following description of the exemplary embodiments, taken in conjunction with the accompanying drawings, in which:
FIG. 1 is a block diagram of a broadcasting signal receiving apparatus according to an exemplary embodiment of the present invention;
FIG. 2 is a circuit diagram of a broadcasting signal receiving apparatus according to an exemplary embodiment of the present invention;
FIG. 3 illustrates a frame structure of a broadcasting signal based on a digital video broadcast-terrestrial 2 (DVB-T2) standard, received through a signal receiver;
FIGs. 4A and 4B are graphs exemplarily showing waveforms of an intermediate frequency (IF) signal before and after passing through a signal filter;
FIG. 5 is a detailed circuit diagram of a first automatic gain control (AGC) detector;
FIG. 6 is a view for explaining generation of a control signal for AGC;
FIGs. 7 and 8 sequentially illustrate the waveforms of the control signal generated in FIG. 6; and
FIG. 9 is a flowchart for explaining a control method of a broadcasting signal receiving apparatus according to an exemplary embodiment of the present invention.

Below, embodiments of the present invention will be described in detail with reference to accompanying drawings so as to be easily realized by a person having ordinary knowledge in the art. The present invention may be embodied in various forms without being limited to the embodiments set forth herein. Descriptions of well-known parts are omitted for clarity, and like reference numerals refer to like elements throughout.

Referring to the accompanying drawings, exemplary embodiments of the present invention are as follows.

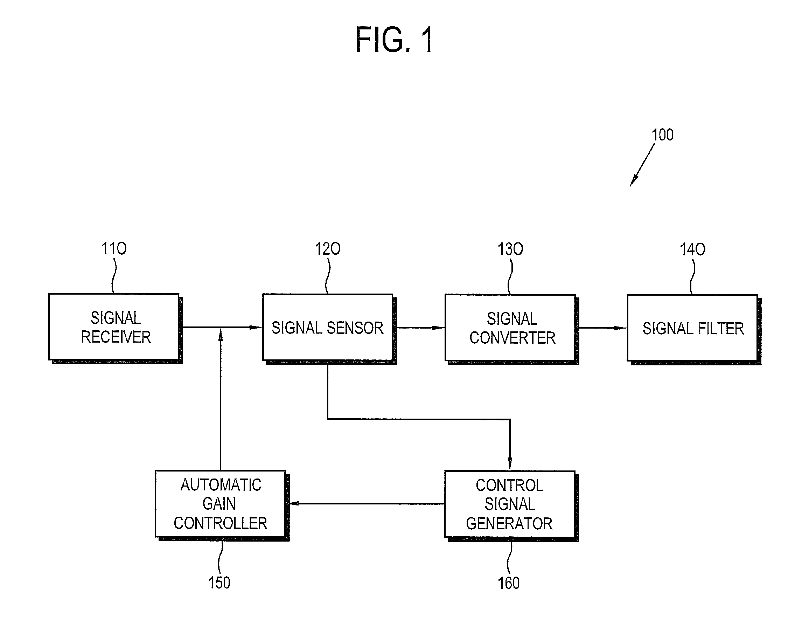

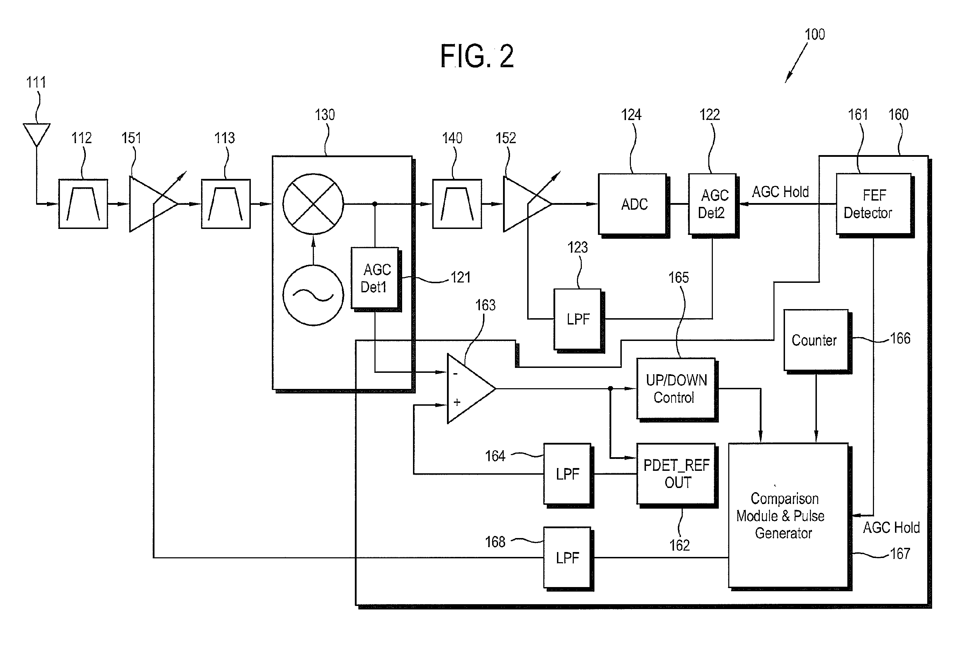

FIG. 1 is a block diagram of a broadcasting signal receiving apparatus according to an exemplary embodiment of the present invention, and FIG. 2 is a circuit diagram of a broadcasting signal receiving apparatus according to an exemplary embodiment of the present invention.

The broadcasting signal receiving apparatus in this embodiment receives a broadcasting signal based on a digital video broadcast-terrestrial 2 (DVB-T2) standard, and may be achieved by a digital television (TV), a set-top box, etc.
As shown in FIG. 1, the broadcasting signal receiving apparatus 100 may include a signal receiver 110, a signal sensor 120, a signal converter 130, a signal filter 140, an automatic gain controller 150, and a control signal generator 160.

The signal receiver 110 receives a broadcasting signal from a broadcasting station. The signal receiver 110 in this embodiment may include an antenna input terminal 111 to receive a broadcasting signal based on the DVB-T2 standard.

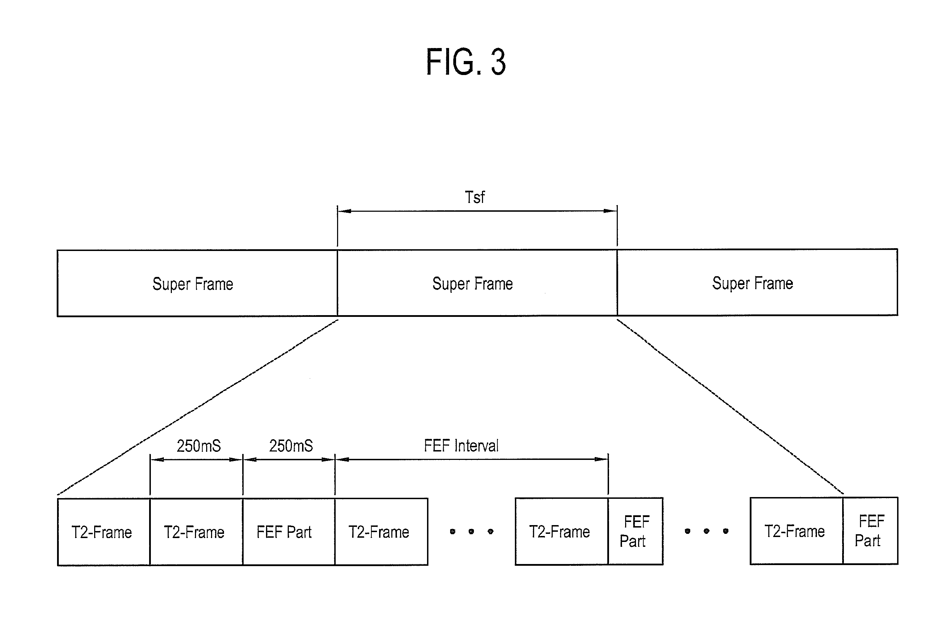

FIG. 3 illustrates a frame structure of a broadcasting signal based on the DVB-T2 standard, received through a signal receiver.

As shown in FIG. 3, a broadcasting signal based on the DVB-T2 is transmitted in the form of a packet including super frames. Each super frame includes T2-frames and future extension frames (FEF).

The future extension frame is prepared as a preliminary part for future standards of a broadcasting system succeeding the DVB-T2 standard. The DVB-T2 standard embeds the future extension frame in a DVB-T2 stream in which broadcasting information is contained. In the case of the DVB-T2 standard, the future extension frame is a section where there is no broadcasting information, and the broadcasting signal from the broadcasting station may selectively include the future extension frame. The future extension frame has a variable length, and may have a length of 250mS such as the maximum T2 frame.

One super frame includes 256 T2 frames. If there is no future extension frame in the super frame, the length of the super frame is Tsf = 250mS × 256 = 64 seconds. In the case that the future extension frames are the most included in the super frame, the super frame includes the future extension frames as many as the number of T2 frames. In this case, the length of the super frame is Tsf = 250mS × (256 + 256) = 128 seconds. In the DVB-T2 standard, the future extension frames are not transmitted successively as being adjacent to each other.

In the DVB-T2 standard, the future extension frame is not decoded as a section where there is no broadcasting information even though it is received in the broadcasting receiving apparatus 100, but has a predetermined signal level. Here, the level of the signal may be higher or lower than that of the preceding T2 frame. Thus, the broadcasting signal receiving apparatus 100 in this embodiment employs the control signal generator 160 to be described later to sense the future extension frames and to generate and provide a control signal to the automatic gain controller 150 so that automatic gain control (AGC) is not implemented in the sensed future extension frame.

In the DVB-T2 standard, information about the future extension frame is embedded in a header part (L2 post signal header) of the preceding T2 frame. Here, the information about the future extension frame includes a starting point, a length, an interval, etc. of the future extension frame.

The broadcasting signal received through the antenna input terminal 111 is a radio frequency (RF) signal having a predetermined frequency band. Here, the signal receiver 110 may includes an input resonant filter 112 to take an RF signal having a frequency band of about 20MHz from the RF signal received via the antenna terminal 111, and an inter-stage resonant filter 113 to take an RF signal having a frequency band of about 12MHz from the RF signal of 20MHz.

The signal receiver 110, the signal sensor 120, the signal converter 130, the signal filter 140 and the automatic gain controller 150 may be provided in a tuner that receives a broadcasting signal and tunes in to a broadcasting signal having a frequency band corresponding to a predetermined tuning control signal.
A digital broadcasting signal tuned to a certain channel undergoes demodulation and error correction of a channel demodulator (not shown) to be output in the form of a transport stream, and is then divided by a demultiplexer (not shown) into a video signal, an audio signal and various appendix data to be output in the form of a bit stream. Further, the video signal divided through the demultiplexer is decoded by a decoder (not shown)and processed by a scaler (not shown) to be displayed on a display unit (not shown).

According to an exemplary embodiment of the present invention, the control signal generator 160 is provided in the channel demodulator.

The signal sensor 120 senses a level of a broadcasting signal received through the signal receiver 110. Here, the broadcasting signal input to the signal sensor 120 may be an RF signal passed through the input resonant filter 112 and the inter-stage resonant filter 113 and having a frequency band of about 12MHz. Further, the signal sensor 120 may include a first AGC detector 121 to detect the level of the broadcasting signal on the basis of energy intensity of the broadcasting signal.
The signal detected by the first AGC detector 121 is a signal for carrying out the AGC of a first AGC amplifier 151 provided in the automatic gain controller 150. The signal detected by the first AGC detector 121 is transmitted to the control signal generator 160 to be described later, and the control signal generator 160 generates a control signal. The first AGC amplifier 151 performs the AGC in response to the control signal.

Meanwhile, according to this embodiment, the signal sensor 120 may further include a second AGC detector 122 to detect a level of an intermediate frequency (IF) signal to be described later.

The signal detected by the second AGC detector 122 is a signal for carrying out the AGC of a second AGC amplifier 152 provided in the automatic gain controller 150. The signal detected by the second AGC detector 122 is filtered through a low pass filter (LPF) 123 and transmitted to the second AGC amplifier 152, thereby carrying out the AGC. The second AGC detector may receive a signal output from an analog/digital converter (ADC) 124.

According to an exemplary embodiment of the present invention, the first AGC detector 121 is provided in a mixer-oscillator-phase locked loop (MOPLL) to be described later, and the second AGC detector 122 is provided in the channel demodulator. Also, the channel demodulator may be achieved by a baseband channel demodulator.

The signal filter 140 filters off a channel signal adjacent to the IF signal output from the signal converter 130. Specifically, the signal filter 140 may be achieved by a saw filter as a band pass filter to pass a desired channel signal with respect to the IF signal and filter out an adjacent channel signal.

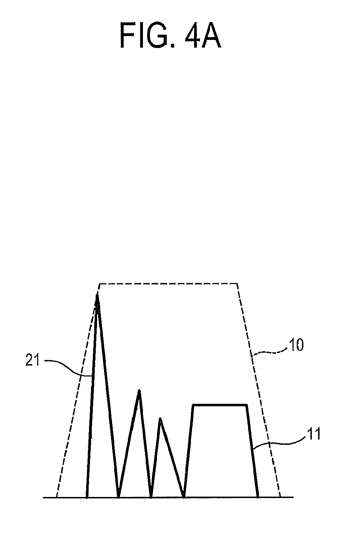

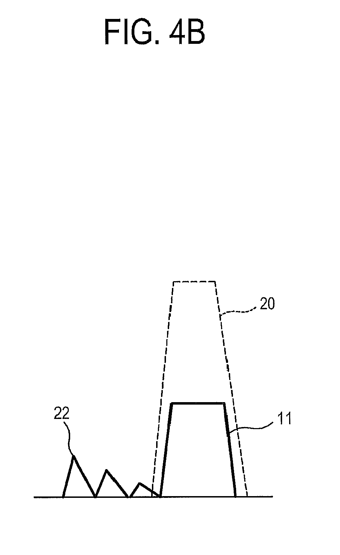

FIGs. 4A and 4B are graphs exemplarily showing waveforms of an intermediate frequency (IF) signal before and after passing through the signal filter 140.
As shown in FIG. 4A, the IF signal output from the signal converter 130 may include not only a desired channel digital signal 11 but also an adjacent channel analog signal 21 having a level higher than that of the desired channel digital signal 11 within a predetermined frequency band 10.

In this case, if the IF signal output from the signal converter 130 passes through the signal filter 140, an adjacent channel signal 22 almost filtered off corresponding to a passed frequency band 20 and the desired channel signal 11 are remained as shown in FIG. 4B.

Thus, the first AGC detector 121 detects the level of the signal of before passing through the signal converter 130, i.e., of which the adjacent channel signal is not filtered off as shown in FIG. 4A, and then performs the AGC, so that adjacent channel interference rate characteristics become better as compared with a case that the AGC is performed by detecting the level of the signal of which the adjacent channel signal is filtered off.

The automatic gain controller 150 performs the AGC to make a broadcasting signal have a certain level according to the level of the broadcasting signal sensed by the signal sensor 120.

In this embodiment, the automatic gain controller 150 includes a first AGC amplifier (RF AGC AMP) 151 to perform the AGC according to the level of the RF signal including the adjacent channel signal detected by the first AGC detector 121, and a second AGC amplifier (IF AGC AMP) 152 to perform the AGC according to the level of the IF signal detected by the second AGC detector 122.

As an automatic gain amplifier that automatically controls a gain to make the level of the signal higher than a medium electric field, i.e., of about +110dBuV ∼ +60dBuV maintain a predetermined reference value (e.g., 1Vp-p), the first AGC amplifier 151 increases the gain if the level of the signal is lower than the reference value (1Vp-p) and decreases the gain if the level of the signal is higher than the reference value (1Vp-p). The second AGC amplifier 152 automatically controls the gain to make the level of the signal lower than the medium electric field, i.e., of about +60dBuV ∼ +25dBuV maintain a predetermined reference value (e.g. 1Vp-p). Here, the first AGC amplifier 151 performs the AGC according to the level of the RF signal of which the adjacent channel signal is not filtered off, and thus the adjacent channel interference rate characteristics become better as compared with a case that the AGC is performed by detecting the level of the signal of which the adjacent channel signal is filtered off.

In more detail, the inter-stage resonant filter 113 processes a frequency band of about 12MHz. If the level of the adjacent channel signal is high, the level of the signal detected by the first AGC detector 121 is also high and thus the first AGC amplifier 151 performs the AGC to lower the level of the signal.

When the first AGC detector 121 detects the level of the RF signal of which the adjacent channel signal is filtered off as shown in FIG. 4B, and provides it to the first AGC amplifier 151, the first AGC amplifier 151 performs the AGC to increase the level of the desired channel signal if the adjacent channel signal has a high level but the desired channel signal has a small level.

In this case, the first AGC amplifier 151 operates in a saturation region because of the high adjacent channel signal, so that nonlinear characteristics of the fist AGC amplifier 151 can cause signal distortion.

Thus, when the first AGC amplifier 151 performs the AGC according to the level of the RF signal of which the adjacent channel signal is filtered off, the adjacent channel interference rate characteristics become worse as compared with a case in this embodiment where the AGC is performed according to the RF signal including the adjacent channel signal. Here, the deteriorated adjacent channel interference rate characteristics may be 10 ∼ 15dB.

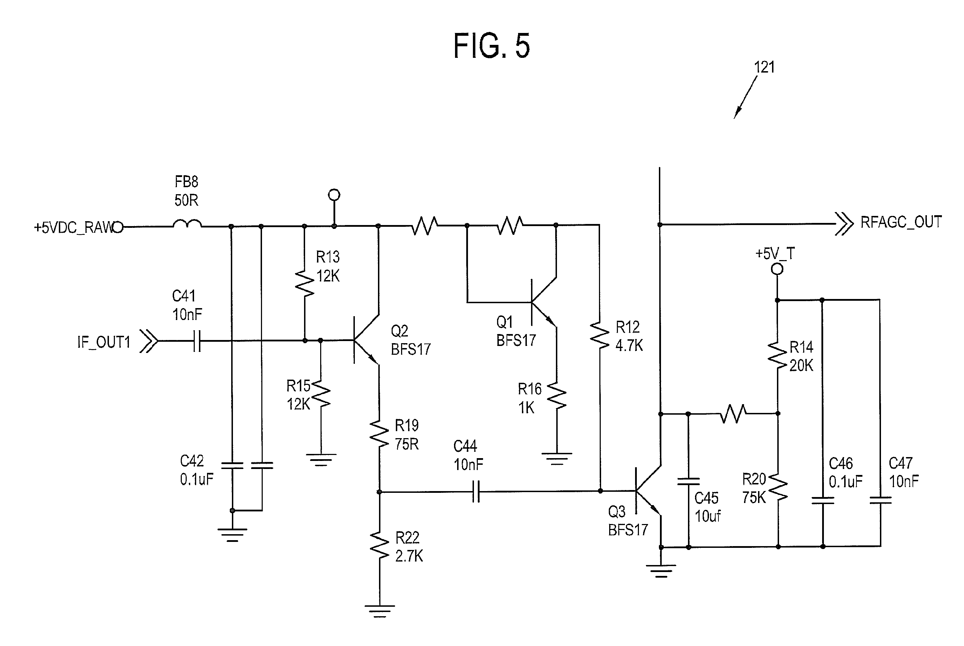

FIG. 5 is a detailed circuit diagram of the first AGC detector 121.

As shown in FIG. 5, the first AGC detector 121 receives a signal from the signal receiver 110 through a base of a transistor Q3. The transistor Q3 is repetitively turned on and off to charge and discharge a condenser C45, thereby outputting a direct current (DC) signal to the first AGC amplifier 151.

Here, if a signal having high energy is input to the base of the transistor Q3, the transistor Q3 is long turned on to prolong the discharge of the condenser C45, so that the AGC is performed to decrease the gain. On the other hand, if a signal having low energy is input to the base, the transistor Q3 is short turned on to prolong the charge of the condenser C45, so that the AGC is performed to increase the gain.

The control signal generator 160 generates a control signal to selectively perform the AGC of the broadcasting signal according to whether the received broadcasting signal is the future extension frame or not.

Specifically, the control signal generator 160 includes an FEF detector 161 to detect the future extension frame of the broadcasting signal. The FEF detector 161 generates a control signal (AGC hold) for controlling the AGC not to be performed in the detected future extension frame and provides it to the automatic gain controller 150.

In this embodiment, that the AGC 150 temporarily holds the AGC in the future extension frame may also be called "freeze."

The FEF detector 161 generates a control signal for freezing the AGC and transmits the control signal to the AGC 150 if it is determined that the broadcasting signal of the future extension frame is received, on the basis of information about the future extension frame included in the header part (L2 post signal header) of the T2 frame. Here, the control signal generator 160 provides both the first AGC amplifier 151 and the second AGC amplifier 152 the control signal for holding the AGC in the future extension frame.

Further, the control signal generator 160 generates an RF control signal for performing the AGC according to the level of the RF signal detected by the first AGC detector 121, and provides it to the first AGC amplifier 151.

Thus, the control signal generator 160 includes a reference value generator 162 for generating a predetermined reference value (RF AGC reference value), and a comparator 163 comparing the level of the signal detected by the first AGC detector 121 with the reference value output from the reference value generator 162.

The comparator 163 outputs either of "1 (e.g., 3.3V)" or "0 (e.g., 0V)" according to comparison results. For example, the comparator 163 compares a level of a DC component output from the first AGC detector 121 with a level of a DC component obtained by passing a signal (PDEF_REF_OUT) generated by the reference valued generator 162 through a low pass filter (LPF) 164, and outputs "0" and "1" if it is low and high, respectively.

A default reference value (RF AGC reference value) is previously set up, and the reference value generator 162 receives an output value of the comparator 163 and changes it into a new reference value, thereby outputting the new reference value. The output value of the reference value generator 162 is transmitted to the comparator 163 via the low pass filter 164.

The control signal generator 160 includes an up/down controller 165 for outputting either an up signal or a down signal according to comparison results of the comparator 163, a counter 166 for outputting a predetermined count signal, a pulse generator 167 for generating a pulse width modulation (PWM) signal having a predetermined pulse width by comparing the output value of the up/down controller 165 with the output value of the counter 166, and a low pass filter (LPF) 168 for outputting a DC signal by integrating

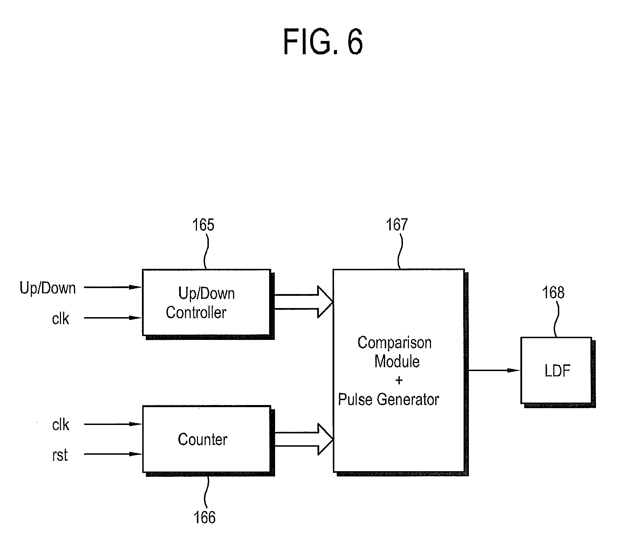

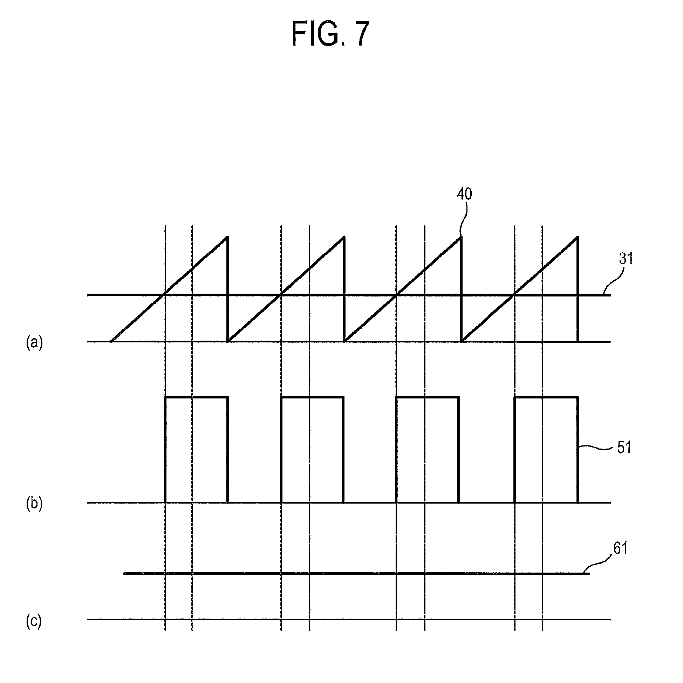

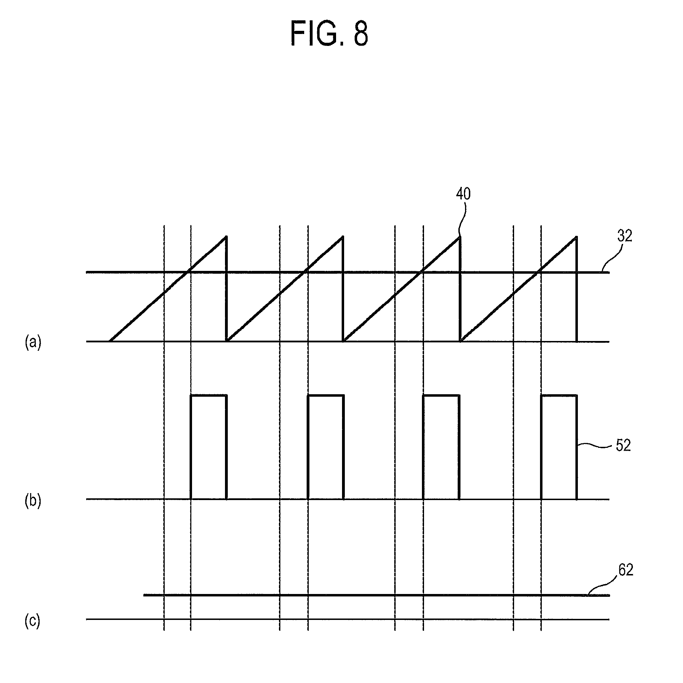

FIG. 6 is a view for explaining generation of a control signal for AGC, and FIGs. 7 and 8 sequentially illustrate the waveforms of the control signal generated in FIG. 6. The up/down controller 165 outputs either of a down signal 31 as shown in (a) of FIG. 7 or an up signal 32 as shown in (a) of FIG. 8 according to comparison results of the comparator 163. That is, if the output value of the comparator 163 is "0," the down signal (e.g., 0V) 31 is output. If the output value of the comparator 163 is "1," the up signal (e.g., 3V) 32 is output.

The counter 166 performs counting in sequence according to free running. That is, an overflow occurs after "11111...11", so that "00000...00" is output, thereby outputting a saw-tooth wave 40.

The pulse generator 167 compares the output value of the up/down controller 165 and the output value of the counter 166, and outputs PWM waveforms 51 and 52 having a predetermined pulse width as shown in (c) of FIG. 7 and (c) of FIG. 8. Here, duty of the PWM waveform is determined by up/down thresholds of the up/down controller 165.

The PWM signal output from the pulse generator 167 is output as an integrated DC signals 61, 62 through the low pass filter 168 (refer to (c) of FIG. 7 and (c) of FIG. 8). The DC signal output through the low pass filter 168 is transmitted to the first AGC amplifier 151, and undergoes the AGC.

Specifically, if a low signal (e.g., not including a high adjacent channel signal) is received as a broadcasting signal in the T2 frame, there is a little difference between the output value of the first AGC detector 121 and the reference value, so that the reference value generator 162 repetitively changes the reference value so that the reference value is equal to the output value of the first AGC detector 121. Thus, the comparator 163 compares the output value of the firs AGC detector 121 with the reference value, thereby repetitively outputting "1," "0," "1," and "0".

Accordingly, the control signal generator 160 determines that the signal is not substantially changed, and does not perform the AGC that controls the level of the broadcasting signal.

On the other hand, if a signal including a high adjacent channel signal is received as a broadcasting signal in the T2 frame, the output value of the first AGC detector 121 is significantly lowered. Thus, the output value of the comparator 163 continuously maintains "0," and the reference value generator 162 repetitively changes the reference value to be equal to the output value of the first AGC detector 121. Thus, the up/down controller 165 continues to operate in a down mode until the reference value is equal to the output value of the first AGC detector 121, thereby outputting a PWM wave form having a wide pulse width as shown in (b) of FIG. 7. Accordingly, the control signal 61 is output as shown in (c) of FIG. 7, and the first AGC amplifier 151 performs the AGC to lower the level of the broadcasting signal.

The pulse generator 167 generates the PWM signal changed in a pulse width according to the change of the reference value, thereby performing the AGC.
In the foregoing broadcasting signal receiving apparatus supporting the DVB-T2 standard, the control signal generator 160 provided in the channel demodulator generates the control signal not to perform the AGC if the broadcasting signal is in the future extension frame, but generates the control signal to perform the AGC according to the level of the detected signal if the broadcasting signal is in the T2 frame, thereby providing the control signal to the automatic gain controller 150. Accordingly, the RF AGC and the IF AGC for the broadcasting signal in the T2 frame and the freeze in the future extension frame are all performed in the channel demodulator, and therefore real-time control thereto is possible.

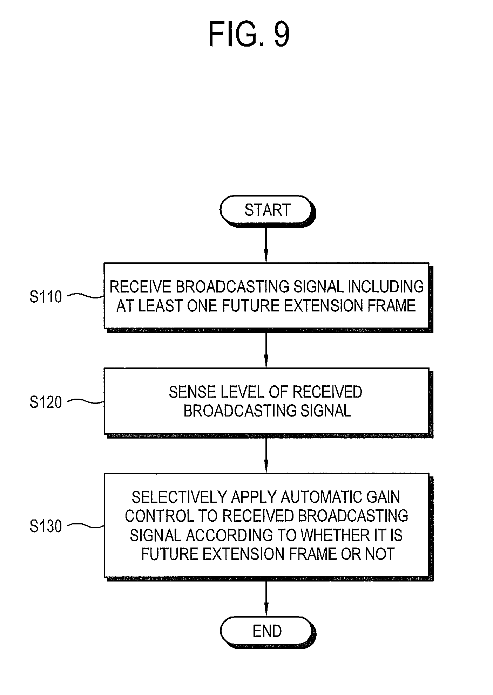

In the broadcasting signal receiving apparatus with the foregoing configuration, a control method thereof will be described below with reference to FIG. 9.

FIG. 9 is a flowchart for explaining a control method of a broadcasting signal receiving apparatus according to an exemplary embodiment of the present invention.

As shown in FIG. 9, at operation S110, the broadcasting signal receiving apparatus 100 receives a broadcasting signal including at least one future extension frame through the broadcasting receiver 110.

At operation S120, the signal sensor 120 senses the level of the received broadcasting signal.

At operation S130, the automatic gain controller 150 selectively applies the AGC to the broadcasting signal according to whether or not the received broadcasting signal is in the future extension frame. Here, the control signal generator 160 detects the future extension frame of the broadcasting signal, and generates the control signal not to perform the AGC in the detected future extension frame, thereby transmitting the control signal to the automatic gain controller 150.

As described above, the present invention provides a broadcasting signal receiving apparatus receiving a broadcasting signal including a future extension frame, which selectively performs AGC according to whether it is the future extension frame or not, thereby preventing the signal from distortion, real-time controlling the AGC to be performed or frozen, and improving adjacent channel interference rate characteristics.

Meanwhile, the foregoing embodiment shows that the broadcasting signal including the FEF is received on the basis of the DVB-T standard, but is not limited to the DVB-T. Alternatively, the present invention may be applied to a broadcasting signal receiving apparatus as long as it receives a broadcasting signal including the future extension frame as a preliminary part.

Although a few exemplary embodiments of the present invention have been shown and described, it will be appreciated by those skilled in the art that changes may be made in these embodiments without departing from the principles and spirit of the invention, the scope of which is defined in the appended claims and their equivalents.

## Claims

1. A broadcasting signal receiving apparatus comprising:
a signal receiver which receives a broadcasting signal comprising at least one future extension frame;
a signal sensor which senses a level of the received broadcasting signal;
an automatic gain controller which performs automatic gain control to make the broadcasting signal have a certain level according to the sensed level of the broadcasting signal; and
a control signal generator which generates a control signal to apply the automatic gain control to the broadcasting signal according to whether the broadcasting signal is in the future extension frame.

2. The broadcasting signal receiving apparatus according to claim 1, wherein the control signal generator detects the future extension frame of the received broadcasting signal, and generates a control signal not to perform the automatic gain control in the detected future extension frame.

3. The broadcasting signal receiving apparatus according to claim 1, wherein the control signal generator comprises:
a reference value generator which generates a predetermined reference value; and
a comparator which compares the level of the sensed broadcasting signal with the reference value, and
the automatic gain controller performs the automatic gain control according to comparison results of the comparator.

4. The broadcasting signal receiving apparatus according to claim 3, further comprising a signal filter which filters off an adjacent channel signal of the received broadcasting signal,
wherein the comparator compares a level of a broadcasting signal of before passing through the signal filter with the reference value.

5. The broadcasting signal receiving apparatus according to claim 3 or 4, wherein the control signal generator comprises
an up/down controller which outputs either of an up signal or a down signal according to the comparison results of the comparator;
a counter which outputs a predetermined count signal; and
a pulse generator which compares an output value of the up/down controller with an output value of the counter, and generates a pulse width modulation (PWM) signal having a predetermined pulse width, and
the automatic gain controller performs the automatic gain control according to an output value of the pulse generator.

6. The broadcasting signal receiving apparatus according to claim 5, wherein the reference value generator changes the reference value to make the output value of the comparator become a new reference value and outputs the new reference value.

7. The broadcasting signal receiving apparatus according to claim 6, wherein the pulse generator generates a pulse width modulation signal changed in the pulse width according to the change of the reference value.

8. The broadcasting signal receiving apparatus according to any one of claims 1 to 4, further comprising a signal converter which converts the received broadcasting signal into a broadcasting signal having an intermediate frequency band,
wherein the automatic gain controller comprises a first automatic gain control amplifier which applies the automatic gain control to the broadcasting signal received in the signal receiver, and a second automatic gain control amplifier which applies the automatic gain control to the broadcasting signal having the intermediate frequency band.

9. A method of controlling a broadcasting signal receiving apparatus, the method comprising:
receiving a broadcasting signal comprising at least one future extension frame;
sensing a level of the received broadcasting signal; and
generating a control signal to apply the automatic gain control to the broadcasting signal according to whether the broadcasting signal is in the future extension frame, and performing automatic gain control to make the broadcasting signal have a certain level according to the sensed level of the broadcasting signal.

10. The method according to claim 9, wherein the performing the automatic gain control comprises detecting the future extension frame of the received broadcasting signal, and generating a control signal not to perform the automatic gain control in the detected future extension frame.

11. The method according to claim 9, wherein the performing the automatic gain control comprises
generating a predetermined reference value; and
comparing the level of the sensed broadcasting signal with the reference value, and
the automatic gain control is performed according to comparison results of the comparator.

12. The method according to claim 11, further comprising filtering off an adjacent channel signal of the received broadcasting signal,
wherein the comparing with the reference value comprises comparing a level of a broadcasting signal of before passing through the signal filter with the reference value.

13. The method according to claim 11 or 12, wherein the comparing with the reference value comprises
outputting either of an up signal or a down signal according to the comparison results of the comparator;
outputting a predetermined count signal; and
generating a pulse width modulation (PWM) signal having a predetermined pulse width by comparing an output value of the up/down controller with an output value of the counter, and
the performing the automatic gain control comprises performing the automatic gain control according to a pulse width of the pulse generator.

14. The method according to claim 13, wherein further comprising changing the reference value to make the output value of the comparator become a new reference value and outputting the new reference value.

15. The method according to any one of claims 9 to 12, further comprising converting the received broadcasting signal into a broadcasting signal having an intermediate frequency band,
wherein the performing the automatic gain control comprises applying the automatic gain control to the broadcasting signal, and applying the automatic gain control to the broadcasting signal having the intermediate frequency band.
